# FASCICULE DE BREVET EUROPEEN

(11) **EP 2 684 434 B1**
(45) Date de publication et mention de la délivrance du brevet: **28.12.2016**
(21) Numéro de dépôt: 12708973.8
(22) Date de dépôt: 06.03.2012
(51) Int. Cl.: H05K 3/32, H05K 3/40, H01L 21/60, H01L 23/00, H05K 3/02, H05K 3/06, H05K 3/12

(54) **PROCÉDÉ D'INTERCONNEXION PAR RETOURNEMENT D'UN COMPOSANT ÉLECTRONIQUE**
VERFAHREN FÜR DEN FLIP-CHIP-ANSCHLUSS EINES ELEKTRONISCHEN BAUTEILS
PROCESS FOR FLIP-CHIP CONNECTION OF AN ELECTRONIC COMPONENT

(30) Priorité: 10.03.2011 FR 1100719
(43) Date de publication de la demande: 15.01.2014
(73) Titulaire: Commissariat à l'Énergie Atomique et aux Énergies Alternatives, 75015 Paris (FR); 3D Plus, 78530 Buc (FR)
(72) Inventeur: LIMOUSIN, Olivier, 91120 Palaiseau (FR); SOUFFLET, Fabrice, 91570 Bièvres (FR)
(74) Mandataire: Gevers & Orès
(86) Numéro de dépôt international: PCT/IB2012/051048
(87) Numéro de publication internationale: WO 2012/120448

(56) Documents cités:
- US-A1- 2005 118 845
- US-A1- 2008 224 309
- US-A1- 2009 026 634

## Description

L'invention porte sur un procédé d'interconnexion par retournement d'un composant électronique sur un substrat.

L'interconnexion par retournement, ou à puce retournée (« flip chip » en anglais), est une technique d'interconnexion très utilisée en électronique. Dans sa forme la plus classique, elle comporte le dépôt de billes métalliques de brasure (« solder balls » en anglais) sur des plages d'interconnexion, typiquement situées sur la face avant d'une puce, le retournement de ladite puce de telle sorte que ladite face avant soit orientée vers la surface de montage d'un substrat, présentant à son tour des plages d'interconnexion, son report sur ledit substrat, puis une application de chaleur pour provoquer la fusion des billes de brasure et réaliser ainsi une interconnexion permanente. Par rapport aux techniques d'interconnexion par fils (« wire bonding » en anglais), le retournement de puce permet une miniaturisation poussée des circuits électroniques et une réduction des inductances parasites. Par contre, cette technique présente aussi des inconvénients, parmi lesquels on peut citer :
- l'application d'une température élevée (généralement supérieure à 100°C, et souvent supérieure à 200°C) à proximité immédiate de la puce électronique, pouvant entrainer une dégradation de cette dernière ; ce problème a été rendu plus aigu, depuis 2006, par le bannissement du plomb dans les alliages de brasure ;
- la nécessité de consolider l'assemblage en remplissant l'espace entre la puce et le substrat avec une résine diélectrique (« underfill »), ce qui peut introduire des capacités parasites et/ou des pertes diélectriques, voire contaminer certains composants sensibles de la puce, tels que des capteurs ;
- une grande sensibilité aux contraintes thermomécaniques engendrées par la dilatation thermique différentielle de la puce et du substrat, qui peuvent amener à la cassure des interconnexions. Ce problème est d'autant plus sérieux que la hauteur des interconnexions est faible ; les documents US 5,598,036 et US 6,657,134 divulguent des techniques d'interconnexion double, permettant d'augmenter ladite hauteur et, par conséquent, de limiter les contraintes thermomécaniques. Cependant, ces procédés sont complexes à mettre en oeuvre.

Des variantes de la technique d'interconnexion par retournement utilisent des colles conductrices, généralement des résines époxydiques chargées en poudre métallique (communément dites « résines époxy conductrices »), pour interconnecter une puce à un substrat en remplacement des billes métalliques de soudure. Ces techniques permettent de travailler à basse température, et conviennent donc au report de puces très fragiles, tels que les capteurs de rayons X en CdTe utilisés pour l'imagerie médicale et pour des applications spatiales. En outre, les matériaux polymères peuvent présenter un module élastique plus faible que celui des métaux, ce qui contribue à limiter les contraintes thermomécaniques.

Les techniques basées sur un dépôt sérigraphique de colle conductrice, telles que celle décrite par le document US 5,074,947, conduisent à des plots présentant un faible facteur de forme (défini comme le rapport entre la hauteur et la plus petite de ses dimensions latérales), de l'ordre de 0,1. Ainsi, des plots de grande hauteur (100 µm ou plus), qui peuvent s'avérer nécessaires pour maintenir les contraintes thermomécaniques à un niveau acceptable, doivent présenter une très grande surface, ce qui conduit à une faible densité d'interconnexion. De plus, la hauteur maximale est limitée par la surface du plus petit plot ; la technique est donc mal adaptée à des motifs d'interconnexion irréguliers, nécessitant des plots d'interconnexion de dimensions différentes et parfois très proches entre eux.

Le document US 7,109,107 décrit une technique de fabrication par lithographie de plots en résine époxydique conductrice. Cette technique permet de réaliser des plots présentant un facteur de forme important (jusqu'à quatre), mais dont la hauteur est limitée à 16 µm environ.

Le document US2005/0118845 divulgue un procédé d'interconnexion par retournement d'un composant électronique sur un substrat, qui comporte la réalisation d'au moins un plot d'interconnexion par gravure d'une couche épaisse non-conductrice.

L'invention vise à remédier aux inconvénients précités de l'art antérieur.

Un objet de l'invention, permettant d'atteindre ce but, est un procédé d'interconnexion par retournement d'un composant électronique sur un substrat, caractérisé en ce qu'il comporte la réalisation d'au moins un plot d'interconnexion par gravure d'une couche épaisse conductrice et son collage, au moyen d'au moins une colle conductrice, entre un plot ou plage d'accueil dudit composant et un plot ou plage d'accueil dudit substrat.

Le composant électronique peut être une puce nue ou encapsulée, un capteur, un circuit hybride, un circuit intégré, etc.

En particulier, le composant électronique peut être une puce. On entend par « puce » tout circuit ou composant électronique réalisé à partir d'une plaquette de cristal semi-conducteur. Il peut s'agir d'un circuit intégré, mais également d'un capteur, notamment matriciel.

Le substrat peut être un circuit imprimé, un bloc électronique tridimensionnel constitué par un empilement de puces et/ou circuits imprimés moulés dans une résine, ou même une puce.

On entend par « couche épaisse » une couche auto-supportant. L'épaisseur à partir de laquelle une couche peut être considérée « épaisse » dépend donc du matériau considéré.

Le procédé de l'invention permet de dissocier la détermination de l'épaisseur des plots conducteurs de leur géométrie dans le plan du substrat et du composant.

Une première variante du procédé de l'invention comporte les étapes suivantes :
(a) la fabrication d'une couche épaisse conductrice ;
(b) son collage, au moyen d'une colle conductrice, à une surface d'un composant électronique ou d'un substrat, présentant au moins un plot ou plage d'accueil ;
(c) la réalisation d'au moins un plot d'interconnexion, en correspondance dudit ou de chaque plot ou plage d'accueil à connecter, par gravure de ladite couche épaisse et de ladite couche mince de colle conductrice ;
(d) le collage, au moyen d'une colle conductrice, dudit ou de chaque plot d'interconnexion à un plot ou plage d'accueil respectif d'un substrat ou d'un composant électronique à interconnecter audit composant électronique ou audit substrat, respectivement.

Une seconde variante du procédé de l'invention comporte les étapes suivantes :
(A) la fabrication d'une couche épaisse conductrice ;
(B) son collage à un substrat temporaire ;
(C) la gravure de ladite couche épaisse, collée audit substrat temporaire, pour former un motif d'interconnexion comprenant au moins un plot d'interconnexion ;
(D) le collage, au moyen d'une colle conductrice, dudit ou de chaque plot d'interconnexion à un plot ou plage d'accueil respectif d'un substrat ou d'un composant électronique ;
(E) le décollement dudit ou de chaque plot d'interconnexion dudit substrat temporaire ; et
(F) le collage, au moyen d'une colle conductrice, dudit ou de chaque plot d'interconnexion à un plot ou plage d'accueil respectif d'un substrat ou d'un composant électronique à interconnecter composant électronique audit composant électronique ou audit substrat, respectivement.

Selon différents modes de réalisation du procédé de l'invention :
- Ladite couche épaisse peut présenter une épaisseur supérieure ou égale à 100 µm, ce qui permet de limiter fortement les contraintes thermomécaniques induites par la dilatation thermique différentielle du composant électronique et du substrat.
- Ledit ou au moins un dit plot d'interconnexion peut présenter une hauteur au moins égale à la moitié de la plus petite de ses dimensions latérales, c'est-à-dire un rapport de forme supérieur ou égal à 0,5. D'une manière encore préférée, le rapport de forme peut être supérieur ou égal à 1.
- Ledit procédé peut comporter une étape de durcissement (notamment par polymérisation ou réticulation) de ladite ou au moins une dite colle conductrice à une température inférieure ou égale à 40°C. On entend par « durcissement » le passage de la colle d'un état visqueux à un état solide ou caoutchouteux.
- Ladite couche épaisse peut être constituée par ladite ou une dite colle conductrice utilisée pour son collage, à l'état durci (par exemple, à l'état polymérisé ou réticulé). Cela présente l'avantage d'aboutir à des plots parfaitement homogènes, dans lesquels aucune interface colle/couche épaisse n'est détectable, et donc plus résistants du point de vue mécanique.
- Ladite ou au moins une dite colle conductrice peut être une résine époxydique contenant une charge conductrice.
- Ladite ou chaque colle conductrice peut être déposée par sérigraphie, sur une surface libre du plot réalisé par gravure de ladite couche épaisse et/ou sur un plot ou plage d'accueil de la puce et/ou du substrat.
- Ledit ou chaque plot d'interconnexion peut être réalisé par gravure laser de ladite couche épaisse.
- Avantageusement, ni ladite ou chaque dite colle conductrice, ni ladite couche épaisse conductrice, ne devraient contenir du plomb.

Un procédé selon un mode de réalisation préféré de l'invention peut permettre l'interconnexion d'au moins un composant disposant de plot d'interconnexions distribués arbitrairement (matriciel, en ligne, etc.), de taille et de forme arbitraire (plots ronds, carrés, etc. ; identiques ou différents entre eux), avec une forte densité d'interconnexion (par exemple, jusqu'à un pas de 300 µm environ, isolés de 100 µm environ) sur un substrat de nature et d'épaisseur quelconques disposant, en regard des plots du composant, des plages d'accueil de motif correspondant permettant une liaison mécanique et/ou électrique. Les plots d'interconnexion peuvent présenter une hauteur relativement importante (100 µm, voire beaucoup plus) et un facteur de forme également important (typiquement, jusqu'à trois), ce qui limite les contraintes mécaniques et thermomécaniques et permet ainsi l'interconnexion de composants et substrats ayant des propriétés thermo-élastiques très différentes (par exemple, un fort écart entre les coefficients de dilatation thermique des matériaux en regard). Par ailleurs, l'interconnexion peut avantageusement se faire à basse température (40°C ou moins), sans soudure au plomb et sans utilisation d'un remplissage de renfort (« underfill »).

D'autres caractéristiques, détails et avantages de l'invention ressortiront à la lecture de la description faite en référence aux dessins annexés donnés à titre d'exemple et qui représentent, respectivement :
- Les figures 1A - 1F, les différentes étapes d'un procédé selon un premier mode de réalisation de l'invention ;
- La figures 2A - 2G, les différentes étapes d'un procédé selon un deuxième mode de réalisation de l'invention ; et
- La figure 3, une vue de détail d'un assemblage constitué par un capteur d'images à rayons X et un bloc tridimensionnel de traitement du signal, réalisé en utilisant un procédé selon l'invention.

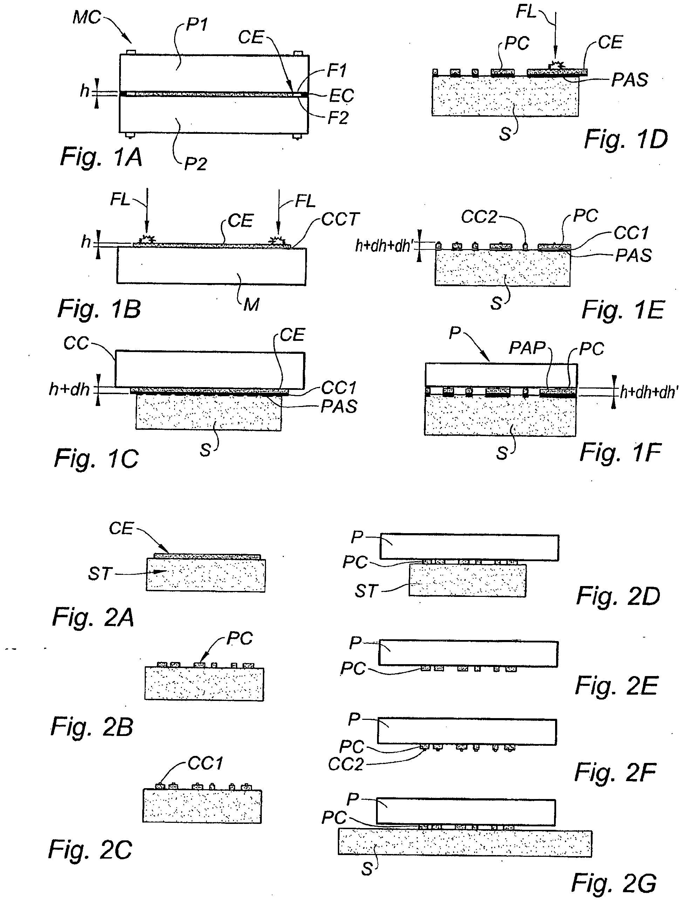

La figure 1A illustre la fabrication par moulage d'une couche épaisse conductrice CE utilisée pour réaliser des plots d'interconnexion, selon un premier mode de réalisation de l'invention.

Le moule calibré MC comprend :
- deux plaques métalliques rectifiées P1 et P2, par exemple en laiton, aluminium ou acier inoxydable, agencées l'une en regard de l'autre et assemblées par des boulons et écrous ;
- deux feuilles anti-adhérentes F1, F2 - par exemple des feuilles de polytétrafluoroéthylène de 50 µm d'épaisseur - recouvrant entièrement les faces opposées des deux plaques ;
- des entretoises calibrées EC, par exemple d'une hauteur h=200 µm±20 µm, posées sur les feuilles anti-adhérentes de manière à délimiter un espace de moulage de hauteur calibrée entre lesdites feuilles.

Une colle ou résine époxydique bi-composante, rendue conductrice par l'ajout d'une charge métallique, pré-mixée et de préférence dégazée (ou « débullée ») sous vide primaire, est injectée dans l'espace de moulage, soumise à une pression par serrage des boulons d'assemblage et polymérisée. A ce stade, la polymérisation peut se faire à chaud, par exemple à 80°C pendant 8 heures. Après ouverture du moule, on peut prélever une membrane ou couche épaisse conductrice CE, qui sera utilisée pour fabriquer des plots d'interconnexion.

Le choix de la résine époxydique utilisée pour la réalisation de la couche épaisse CE dépend de l'application envisagée. De préférence, cette résine pourra présenter les propriétés thermomécaniques et physico-chimiques suivantes :
- température de transition vitreuse inférieure à la température minimale de fonctionnement du composant électronique, et module d'élasticité inférieur ou égal à 200 MPa, et de préférence inférieur ou égal à 100 MPa, dans la zone caoutchoutique ;
- tenue au cisaillement supérieure ou égale à 10 MPa ;
- résistivité volumique inférieure ou égale à 0,05 Ohm.cm.

Il peut s'agir par exemple d'une colle Epotek H20F, utilisant une charge conductrice en argent.

Selon différentes variantes de l'invention, l'on pourra utiliser une colle ou résine époxydique bi- ou mono-composant, ou bien silicone, polyimide, acrylate, polyester, etc. avec une charge conductrice en argent, or, nickel, etc.

La figure 1B montre la couche épaisse conductrice CE simplement posée sur un substrat intermédiaire M dit « martyre » pour être prédécoupée au laser (faisceau laser FL, par exemple présentant une longueur d'onde de 1064 nm, pouvant être généré par un laser Nd :YAG, ou grenat d'yttrium et aluminium dopé au néodyme). Le « martyre » peut, par exemple, être en verre avec une planéité meilleure que 20 µm. Cette étape de prédécoupe est optionnelle.

Lors de l'étape suivante, illustré sur la figure 1C, la couche épaisse conductrice prédécoupée CE est reportée sur le substrat S, et collée sur ce dernier au moyen d'une colle conductrice, déposée sur la couche CE elle-même et/ou sur le substrat S et formant une couche CC1 d'épaisseur dh. Typiquement, l'épaisseur dh est inférieure ou égale à un dixième de celle, h, de la couche épaisse. Avantageusement, la colle conductrice peut être la même utilisée pour la fabrication de la couche CE ; en tout cas, elle doit pouvoir adhérer aux plages ou plots métalliques « d'accueil » PAS, présents à la surface du substrat S. Le collage est accompagné d'une compression de la couche mince sur le substrat par l'intermédiaire d'une cale CC.

Ensuite, comme montré sur la figure 1 D, la couche épaisse CE est gravée au laser (faisceau FL, qui peut être le même utilisé lors de l'étape de prédécoupe, bien que cela ne soit pas essentiel) selon un motif d'interconnexion déterminé pour définir des plots conducteurs PC en correspondance des plages ou plots métalliques d'accueil PAS à la surface du substrat. Cette étape de gravure laser est délicate, car il est nécessaire d'enlever complètement la colle conductrice en dehors des plots conducteurs PC afin d'éviter des courts-circuits, sans toutefois endommager la surface du substrat.

L'étape suivante, représentée sur la figure 1 E, comporte le dépôt localisé d'une couche mince de colle conductrice CC2 sur les surfaces libres des plots conducteurs PC. La colle peut être typiquement la même utilisée pour la couche CC1 et éventuellement pour la couché épaisse CE ; en tout cas, elle doit pouvoir adhérer aux plages ou plots métalliques d'accueil PAP, présents à la surface de la puce P à reporter. L'épaisseur dh' de la couche CC2 est typiquement du même ordre de grandeur de dh, et très inférieure à h. Le dépôt localisé de la colle conductrice peut se faire par sérigraphie.

Ensuite, la figure 1F illustre le report par retournement d'une puce P, présentant des plots ou plages d'accueil PAP en correspondance des plots conducteurs PC ; cette opération de report est conventionnelle. L'interconnexion est consolidée en appliquant une pression - qui peut être relativement faible, de l'ordre de 100 ou 200 g/cm², voire moins - et en provoquant une polymérisation de la colle des couches, de préférence à basse température (par exemple, à 35°C pendant 3 jours) afin de ne pas endommager la puce.

En variante, la couche CE peut être d'abord collée sur la puce P, puis gravée, auquel cas c'est le substrat S à être rapporté par retournement.

Les figures 2A à 2G illustrent un mode de réalisation alternatif du procédé de l'invention, particulièrement adapté au cas où le substrat est très sensible à l'ablation laser de la couche CE.

Les étapes de fabrication et prédécoupe éventuelle de la couche épaisse CE ne sont pas représentées ; elles correspondent à celles décrites plus haut en référence aux figures 1A et 1B. Ladite couche CE est fixée de manière temporaire à un substrat temporaire ST ; ce dernier peut être constitué par exemple par un adhésif sensible à la chaleur (an anglais :« thermo-release ») de type NITTO RevAlpha 3195V (figure 2A). Ensuite, la couche CE est gravée au laser selon un motif d'interconnexion pour former les plots conducteurs PC (figure 2B). Une couche mince CC1 de colle conductrice est déposée localement, par exemple par sérigraphie, sur les surfaces libres desdits plots (figure 2C). La puce P (ou le substrat S) est rapportée par retournement, en faisant correspondre les plots PC recouverts de colle à ses plages ou plots d'accueil PAP (figure 2D). Ensuite, le substrat temporaire est retiré (figure 2E), une deuxième couche mince de colle conductrice CC2 est déposée, également par sérigraphie, sur les surfaces nouvellement libérées des plots conducteurs (figure 2F). Puis (figure 2G) la puce est reportée sur le substrat S, en veillant à l'alignement des plots PC avec les plages ou plots d'accueil PAS à la surface de ce dernier.

En variante ou en complément, tant dans le premier que dans le deuxième mode de réalisation du procédé de l'invention, le dépôt sélectif de colle conductrice (figures 1 E, 2C, 2F) peut se faire sur les plots ou plages d'accueil de la puce et/ou du substrat.

La gravure laser peut être remplacée par une gravure par attaque chimique, par plasma, par faisceau ionique ou d'électrons, voire par jet d'eau, ou même par sciage. Ce dernier cas, cependant, ne permet que la réalisation d'un motif d'interconnexion en forme de quadrillage.

La couche épaisse conductrice CE peut présenter une conductivité isotrope ou anisotrope. Elle ne doit pas nécessairement être polymère ; en variante il peut s'agir, par exemple, d'une feuille métallique, notamment en or. Il est même possible d'envisager l'utilisation d'une couche composite, comprenant des régions conductrices (pour la réalisation de plots conducteurs d'interconnexion électrique) et des régions isolantes (pour la réalisation de plots ayant uniquement une fonction mécanique).

L'invention a été décrite dans son application au report d'une puce sur un substrat mais, comme indiqué plus haut, elle peut convenir à l'interconnexion de tout composant électronique.

Le procédé selon le premier mode de réalisation de l'invention a été appliqué à la fixation d'un détecteur matriciel (« pixélisé ») de rayons X à un bloc électronique d'acquisition ; il s'agit d'une évolution de la micro-caméra à rayons X durs « Caliste 64 » décrite dans l'article de A. Meuris et al. « Caliste 64, an Innovative CdTe Hard X-Ray Micro Camera », IEEE Trans. Nucl. Sci. 55, No. 2, pp. 778-784, avril 2008. Le détecteur D (la puce) est essentiellement constitué par un cristal de CdTe de 1mm d'épaisseur, décomposé en 16x16 pixels et présentant une surface de 10 mm x 10 mm. Le bloc électronique d'acquisition B (le substrat) se présente sous la forme d'un parallélépipède de dimensions 10 mm x 10 mm x 20 mm, formé par un empilement de huit circuits intégrés CI1 - CI8 moulés dans une résine. Des contacts de grille brasés CG, issus des circuits intégrés, affleurent à la surface supérieure du bloc B, où ils rentrent en contact avec une couche de métallisation CM pour former un motif d'interconnexion sous la forme d'une matrice de 16 x 16 plages d'accueil au pas de 580 µm, avec un anneau de garde externe ayant une largeur de 200 µm. La surface inférieure du détecteur présente un motif d'interconnexion correspondant.

Cette application est particulièrement contraignante car :
- le détecteur D ne supporte pas des températures supérieures à 40°C ;
- le détecteur et le bloc électronique présentent des coefficients de dilatation thermique très différents entre eux : 5,9 ppm/K pour le détecteur, 18 ppm/K pour le bloc électronique ;
- le bloc électronique présente une épaisseur importante (20 mm), ce qui rend difficile l'application de chaleur à la région d'interconnexion ;
- la surface supérieure du bloc électronique présente une planéité de 20 µm sur 10 mm, ce qui pourrait conduire à des défauts de contact ;
- le motif d'interconnexion est dense, et comporte un anneau de garde difficile à réaliser par des techniques conventionnelles ;
- l'ensemble est prévu pour des applications spatiales, ce qui limite le choix des matériaux utilisables.

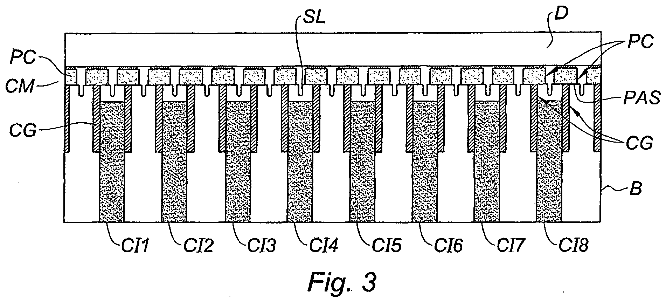

Le procédé de l'invention a permis de réaliser des plots d'interconnexion de 140 à 200 µm d'épaisseur, avec des facteurs de forme de 3/8 et 4/10 respectivement, assurant une très bonne tolérance aux contraintes thermomécanique et une compensation des défauts de planéité du substrat. La figure 3 montre une vue en coupe de la région d'interconnexion de l'ensemble bloc-détecteur. On remarque les sillons SL provoqués par la gravure laser des plots conducteurs ; en l'espèce, ces sillons sont réalisés de manière volontaire afin de former les plages d'accueil PAS en réalisant un quadrillage de la couche métallique CM. Dans d'autres applications, la fluence du laser pourrait être réduite pour ne graver que la couche épaisse conductrice.

## Revendications

1. Procédé d'interconnexion par retournement d'un composant électronique (P, D) sur un substrat (S, B), **caractérisé en ce qu'**il comporte la réalisation d'au moins un plot d'interconnexion (PC) par gravure d'une couche épaisse conductrice (CE) et son collage, au moyen d'au moins une couche mince de colle conductrice, entre un plot ou plage d'accueil dudit composant (PAP) et un plot ou plage d'accueil dudit substrat (PAS).

2. Procédé selon la revendication 1, comportant les étapes suivantes :
(a) la fabrication d'une couche épaisse conductrice (CE) ;
(b) son collage, au moyen d'une colle conductrice, à une surface d'un composant électronique ou d'un substrat, présentant au moins un plot ou plage d'accueil ;
(c) la réalisation d'au moins un plot d'interconnexion, en correspondance dudit ou de chaque plot ou plage d'accueil à connecter, par gravure de ladite couche épaisse et de ladite couche mince de colle conductrice ;
(d) le collage, au moyen d'une colle conductrice, dudit ou de chaque plot d'interconnexion à un plot ou plage d'accueil respectif d'un substrat ou d'un composant électronique à interconnecter audit composant électronique ou audit substrat, respectivement.

3. Procédé selon la revendication 1, comportant les étapes suivantes :
(A) la fabrication d'une couche épaisse conductrice ;
(B) son collage à un substrat temporaire (ST) ;
(C) la gravure de ladite couche épaisse, collée audit substrat temporaire, pour former un motif d'interconnexion comprenant au moins un plot d'interconnexion ;
(D) le collage, au moyen d'une colle conductrice, dudit ou de chaque plot d'interconnexion à un plot ou plage d'accueil respectif d'un substrat ou d'un composant électronique ;
(E) le décollement dudit ou de chaque plot d'interconnexion dudit substrat temporaire ; et
(F) le collage, au moyen d'une colle conductrice, dudit ou de chaque plot d'interconnexion à un plot ou plage d'accueil respectif d'un substrat ou d'un composant électronique à interconnecter audit composant électronique ou audit substrat, respectivement.

4. Procédé selon l'une des revendications précédentes, dans lequel ledit composant électronique est une puce.

5. Procédé selon l'une des revendications précédentes, dans lequel ledit ou chaque plot d'interconnexion est réalisé par gravure laser de ladite couche épaisse.

6. Procédé selon l'une des revendications précédentes, dans lequel ladite couche épaisse présente une épaisseur supérieure ou égale à 100 µm.

7. Procédé selon l'une des revendications précédentes, dans lequel ledit ou au moins un dit plot d'interconnexion présente une hauteur au moins égale à la moitié de la plus petite de ses dimensions latérales.

8. Procédé selon l'une des revendications précédentes, comportant une étape de durcissement de ladite ou au moins une dite couche mince de colle conductrice à une température inférieure ou égale à 40°C.

9. Procédé selon l'une des revendications précédentes, dans lequel ladite couche épaisse est constituée par ladite ou une dite couche mince de colle conductrice utilisée pour son collage, à l'état durci.

10. Procédé selon l'une des revendications précédentes, dans lequel ladite ou au moins une dite couche mince de colle conductrice est une résine époxydique contenant une charge conductrice.

11. Procédé selon l'une des revendications précédentes, dans lequel ladite ou chaque couche mince de colle conductrice est déposée par sérigraphie.

12. Procédé selon l'une des revendications précédentes, dans lequel ni ladite ou chaque dite couche mince de colle conductrice, ni ladite couche épaisse conductrice, ne contiennent du plomb.

## Patentansprüche

1. Verfahren für den Flip-Chip-Anschluss eines elektronischen Bauteils (P, D) auf einem Substrat (S, B), **dadurch gekennzeichnet, dass** es die Herstellung mindestens eines Anschlusskontakts (PC) durch Gravur einer dicken leitenden Schicht (CE) und sein Kleben mit Hilfe von mindestens einer dünnen Schicht leitenden Klebers zwischen einem Kontakt oder einem Aufnahmebereich des Bauteils (PAP) und einem Empfangskontakt oder -bereich des Substrats (PAS) aufweist.

2. Verfahren nach Anspruch 1, umfassend die folgenden Schritte:
(a) Herstellen einer dicken leitenden Schicht (CE),
(b) ihr Kleben mittels eines leitenden Klebers auf eine Oberfläche eines elektronischen Bauteils oder eines Substrats, das mindestens einen Empfangskontakt oder -bereich aufweist,
(c) Herstellen mindestens eines Anschlusskontakts in Entsprechung des oder jedes anzuschließenden Empfangskontakts oder -bereichs durch Gravur der dicken Schicht und der dünnen Schicht leitenden Klebers,
(d) Verkleben mit Hilfe eines leitenden Klebers des oder jedes Anschlusskontakts mit einem jeweiligen Empfangskontakt oder -bereich eines Substrats oder eines elektronischen Bauteils, der mit dem jeweiligen elektronischen Bauteil oder dem Substrat zu verbinden ist.

3. Verfahren nach Anspruch 1, umfassend die folgenden Schritte:
(A) Herstellen einer dicken leitenden Schicht,
(B) ihr Kleben auf ein temporäres Substrat (ST),
(C) Gravieren der mit dem temporären Substrat verklebten dicken Schicht, um ein Flip-Chip-Motiv zu bilden, das mindestens einen Anschlusskontakt umfasst,
(D) Verkleben mit Hilfe eines leitenden Klebers des oder jedes Anschlusskontakts mit einem jeweiligen Empfangskontakt oder -bereich eines Substrats oder eines elektronischen Bauteils,
(E) Lösen des oder jedes Anschlusskontakts vom temporären Substrat, und
(F) Verkleben mit Hilfe eines leitenden Klebers des oder jedes Anschlusskontakts mit einem jeweiligen Empfangskontakt oder -bereich eines Substrats oder eines elektronischen Bauteils, der mit dem jeweiligen elektronischen Bauteil oder dem Substrat zu verbinden ist.

4. Verfahren nach einem der vorangehenden Ansprüche, wobei das elektronische Bauteil ein Chip ist.

5. Verfahren nach einem der vorangehenden Ansprüche, wobei der oder jeder Anschlusskontakt durch Lasergravur der dicken Schicht hergestellt ist.

6. Verfahren nach einem der vorangehenden Ansprüche, wobei die dicke Schicht eine Dicke über oder von gleich 100 µm aufweist.

7. Verfahren nach einem der vorangehenden Ansprüche, wobei der oder mindestens ein Anschlusskontakt eine Höhe von mindestens gleich der Hälfte der kleinsten seiner seitlichen Abmessungen aufweist.

8. Verfahren nach einem der vorangehenden Ansprüche, umfassend einen Schritt des Härtens der oder mindestens einer dünnen Schicht leitenden Klebers bei einer Temperatur unter oder von gleich 40 °C.

9. Verfahren nach einem der vorangehenden Ansprüche, wobei die dicke Schicht von der oder einer dünnen Schicht leitenden Klebers, der für ihr Verkleben verwendet wird, in gehärtetem Zustand gebildet ist.

10. Verfahren nach einem der vorangehenden Ansprüche, wobei die oder mindestens eine dünne Schicht leitenden Klebers ein Epoxidharz ist, das eine leitende Charge enthält.

11. Verfahren nach einem der vorangehenden Ansprüche, wobei die oder jede dünne Schicht leitenden Klebers durch Siebdruck aufgebracht wird.

12. Verfahren nach einem der vorangehenden Ansprüche, wobei weder die oder jede dünne Schicht leitenden Klebers, noch die dicke leitende Schicht Blei enthalten.

## Claims

1. A flip-chip process for interconnecting an electronic component (P, D) and a substrate (S, B), **characterized in that** it comprises producing at least one interconnect pad (PC) by etching a thick conductive layer (CE) and adhesively bonding it, by means of at least one thin layer of conductive adhesive, between a receiving pad or land (PAP) of said component and a receiving pad or land (PAS) of said substrate.

2. The process as claimed in claim 1, comprising the following steps:
(a) manufacturing a thick conductive layer (CE);
(b) adhesively bonding it, by means of a conductive adhesive, to an area of an electronic component or of a substrate having at least one receiving pad or land;
(c) producing at least one interconnect pad, in correspondence with said or each receiving pad or land to be connected, by etching said thick layer and said thin layer of conductive adhesive; and
(d) adhesively bonding, by means of a conductive adhesive, said or each interconnect pad to a respective receiving pad or land of a substrate or of an electronic component to be interconnected with said electronic component or said substrate, respectively.

3. The process as claimed in claim 1, comprising the following steps:
(A) manufacturing a thick conductive layer;
(B) adhesively bonding it to a temporary substrate (ST) ;
(C) etching said thick layer, bonded to said temporary substrate, in order to form an interconnect pattern comprising at least one interconnect pad;
(D) bonding, by means of a conductive adhesive, said or each interconnect pad to a respective receiving pad or land of a substrate or of an electronic component;
(E) debonding said or each interconnect pad from said temporary substrate; and
(F) bonding, by means of a conductive adhesive, said or each interconnect pad to a respective receiving pad or land of a substrate or of an electronic component to be interconnected with said electronic component or said substrate, respectively.

4. The process as claimed in one of the preceding claims, in which said electronic component is a chip.

5. The process as claimed in one of the preceding claims, in which said or each interconnect pad is produced by laser etching said thick layer.

6. The process as claimed in one of the preceding claims, in which said thick layer has a thickness larger than or equal to 100 µm.

7. The process as claimed in one of the preceding claims, in which said or at least one said interconnect pad has a height at least equal to half the smallest of its lateral dimensions.

8. The process as claimed in one of the preceding claims, comprising a step of setting said or at least one said thin layer of conductive adhesive at a temperature of 40°C or less.

9. The process as claimed in one of the preceding claims, in which said thick layer consists of said or a said thin layer of conductive adhesive used for its adhesive bonding, in the set state.

10. The process as claimed in one of the preceding claims, in which said or at least one said thin layer of conductive adhesive is an epoxy resin containing a conductive filler.

11. The process as claimed in one of the preceding claims, in which said or each thin layer of conductive adhesive is deposited by screen printing.

12. The process as claimed in one of the preceding claims, in which neither said or each said thin layer of conductive adhesive nor said thick conductive layer contains lead.
